# FASCICULE DE BREVET EUROPEEN

(11) **EP 2 673 391 B1**
(45) Date de publication et mention de la délivrance du brevet: **28.01.2015**
(21) Numéro de dépôt: 12707867.3
(22) Date de dépôt: 06.02.2012
(51) Int. Cl.: C23C 14/34

(54) **DISPOSITIF ET PROCEDE DE PULVERISATION IONIQUE**
VORRICHTUNG UND VERFAHREN FÜR IONENSTRAHL-SPUTTERING
DEVICE AND METHOD FOR ION BEAM SPUTTERING

(30) Priorité: 08.02.2011 FR 1150981
(43) Date de publication de la demande: 18.12.2013
(73) Titulaire: Centre National de la Recherche Scientifique, 75794 Paris Cedex 16 (FR)
(72) Inventeur: SORTAIS, Pascal, F-38240 Meylan (FR); LAMY, Thierry, F-38000 Grenoble (FR)
(74) Mandataire: Thibon, Laurent
(86) Numéro de dépôt international: PCT/FR2012/050250
(87) Numéro de publication internationale: WO 2012/107674

(56) Documents cités:
- FR-A1- 2 937 494
- US-A1- 2001 045 352

## Description

### Domaine de l'invention

La présente invention concerne un dispositif et des procédés de pulvérisation ionique, c'est-à-dire de dépôt de particules sur un substrat, celles-ci étant produites par le bombardement par un ou plusieurs faisceaux d'ions d'une cible constituée d'un ou plusieurs matériaux choisis ou de plusieurs cibles de divers matériaux choisis.

### Exposé de l'art antérieur

Dans un dispositif de pulvérisation ionique, un faisceau d'ions relativement lourds, par exemple de l'argon, est dirigé vers une cible pour produire la pulvérisation de particules du ou des matériaux constituant cette cible. Une partie au moins de ces particules vient se déposer sur un substrat pour y former une couche mince du ou des matériaux.

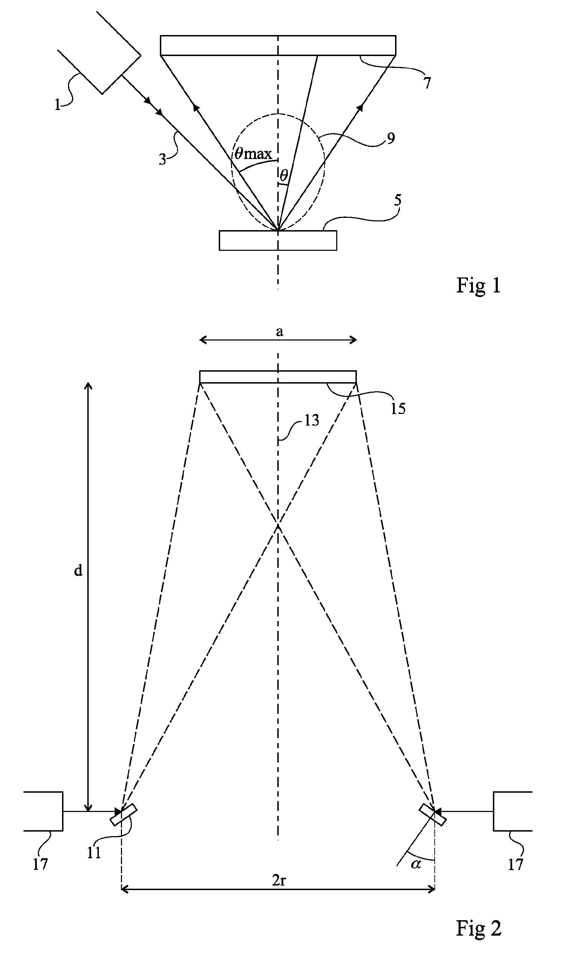

La figure 1 illustre très schématiquement le principe d'un dépôt par pulvérisation ionique. Une source d'ions 1 émet un faisceau d'ions 3 en direction d'une cible 5 et la zone bombardée de la cible pulvérise des particules du matériau de la cible qui sont notamment reçues sur un substrat 7 sur lequel on veut déposer le matériau en question. Ce substrat est généralement disposé dans un plan parallèle au plan de la cible et le point d'impact du faisceau d'ions sur la cible est disposé à l'intersection de la cible et de la normale au centre du substrat. L'angle entre cette normale et un bord extrême du substrat est appelé θₘₐₓ.

On a également représenté en figure 1 par une courbe en pointillés 9 la quantité de particules émises en fonction de l'angle θ par rapport à la normale à la cible. On voit que cette quantité est maximum dans la direction normale à la cible et décroît quand l'angle θ augmente. De façon générale, on considère que la densité de particules est définie par une fonction du type (cosθ)ⁿ, n étant généralement compris entre 1 et 3. Ainsi le dépôt du matériau pulvérisé sur le substrat 7 sera plus épais au centre du substrat qu'à la périphérie de celui-ci.

Pour pallier cet inconvénient et obtenir un dépôt d'épaisseur sensiblement constante sur le substrat, divers moyens ont été proposés dans l'art antérieur parmi lesquels on peut citer les suivants.
- Eloignement du substrat par rapport à la cible pour que l'angle θₘₐₓ soit petit et compris dans la zone supérieure pratiquement plate de la courbe 9. Ceci conduit à des installations de grandes dimensions, la distance entre la cible et le substrat étant par exemple de l'ordre du mètre. Il faut donc prévoir des enceintes, mises sous vides, de grandes dimensions, ce qui entraîne que les durées de mise sous vide sont importantes, qu'il faut prévoir des systèmes de pompage puissants, et qu'il faut évaluer avec précision la résistance mécanique de l'enceinte à la pression atmosphérique.
- Agrandissement de la surface de la cible, la surface irradiée de la cible pouvant atteindre sensiblement la surface du substrat. Cette solution pose également des problèmes, notamment pour obtenir une irradiation sensiblement homogène de la cible et entraîne des coûts élevés pour l'obtention de cibles de grandes dimensions en matériaux ultra-purs.
- Utilisation de divers déflecteurs électromagnétiques pour homogénéiser la répartition du faisceau d'ions sur la cible et/ou pour homogénéiser la répartition des particules de matériaux sur le substrat. Cette solution est complexe à mettre en oeuvre et augmente le coût des installations.
- Utilisation de systèmes mécaniques de déplacement du substrat, selon un mouvement linéaire, ou par des structures de type planétaire. A nouveau cette solution est complexe à mettre en oeuvre et augmente la taille et le coût des installations.
- Utilisation de plusieurs sources d'ions pour bombarder une cible de grande surface. En pratique, il est difficile d'obtenir une irradiation homogène de la cible sur une grande surface.

D'autre part, dans la plupart des installations connues, une même chambre est utilisée pour la source d'ions, et la cible et le substrat constituant la zone de vaporisation. Même si on essaie d'utiliser des chambres distinctes, ces chambres communiquent par une ouverture de grande dimension propre à laisser passer un faisceau d'ions de grande section. Ceci pose des problèmes d'optimisation.

US2001/045352 A1 divulgue un dispositif de dépôt par pulvérisation ionique comprenant une pluralité de cibles dont chacune est bombardée par un faisceau d'ions.

Ainsi, il existe un besoin pour une installation de pulvérisation ionique améliorée.

### Résumé

Un objet de modes de réalisation de la présente invention est de prévoir une installation de pulvérisation ionique palliant au moins certains des inconvénients des installations selon l'art antérieur.

Un objet plus particulier de la présente invention est de prévoir une installation de pulvérisation ionique permettant d'obtenir un dépôt d'épaisseur régulière sur une cible et/ou d'obtenir un dépôt dont l'épaisseur varie en fonction de l'emplacement sur la cible selon une règle prédéterminée.

Un autre objet de la présente invention est de prévoir une telle installation dans laquelle on puisse obtenir des pressions pratiquement indépendantes dans la zone de source d'ions et dans la zone de pulvérisation proprement dite.

Ainsi, un mode de réalisation de la présente invention prévoit un dispositif selon la revendication 1 de dépôt d'un matériau choisi sur un substrat par pulvérisation ionique, comprenant une pluralité de cibles d'un matériau choisi dont chacune est bombardée par un faisceau d'ions, les dimensions latérales de chacun des faisceaux d'ions étant inférieures au dixième des dimensions latérales du substrat.

Selon un mode de réalisation de la présente invention, le dispositif est adapté au dépôt de plusieurs matériaux choisis et comprend plusieurs pluralités de cibles, chaque pluralité étant associée à un matériau.

Selon un mode de réalisation de la présente invention, les cibles sont réparties de façon symétrique autour d'un axe de symétrie orthogonal au substrat et inclinées par rapport à la normale à celui-ci.

Selon un mode de réalisation de la présente invention, les cibles sont disposées côte à côte en deux lignes de part et d'autre dudit axe et constituent deux surfaces d'un prisme.

Selon un mode de réalisation de la présente invention, les cibles sont réparties circulairement et constituent la surface d'un cône.

Selon un mode de réalisation de la présente invention, le dispositif comprend une chambre de pulvérisation et une chambre contenant les sources de faisceaux d'ions, ces chambres étant séparées par une paroi munie d'ouvertures de petite section, correspondant à la section des faisceaux d'ions, et des moyens de pompage propres à entretenir des vides dynamiques distincts dans les deux chambres.

Selon un mode de réalisation de la présente invention, le dispositif comprend un système de déplacement de l'ensemble des cibles, en rotation et/ou en translation.

Selon un mode de réalisation de la présente invention, le dispositif comprend un système de mesure du courant ionique de chaque faisceau placé sous l'ensemble des cibles et mobile avec celui-ci.

Selon un mode de réalisation de la présente invention, le dispositif comprend en outre un système assurant au moins l'une des fonctions suivantes : mise en rotation-translation, chauffage et/ou immersion plasma, bombardement ionique et/ou cache, et polarisation du substrat.

Un mode de réalisation de la présente invention prévoit un procédé selon la revendication 9 de dépôt d'un ou plusieurs matériaux choisis sur un substrat par pulvérisation ionique, comprenant les étapes suivantes : disposer une pluralité de cibles de dimensions latérales inférieures au dixième des dimensions latérales du substrat autour d'un axe orthogonal au substrat ; bombarder chacune des cibles par un faisceau d'ions ; et sélectionner la distance entre cibles, la distance entre cibles et substrat et l'orientation des cibles par rapport au substrat pour obtenir un profil de dépôt choisi sur le substrat.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, décrite précédemment, est une vue schématique illustrant un processus de pulvérisation par faisceau ionique ;
la figure 2 est une vue schématique illustrant le principe de fonctionnement d'un dispositif de pulvérisation ionique selon un mode de réalisation de la présente invention ;
les figures 3A à 3C sont des courbes illustrant des variations d'épaisseur d'une couche déposée en fonction de paramètres géométriques d'une installation de pulvérisation ionique du type de celle de la figure 2 ;
la figure 4 est une vue en perspective illustrant une installation de pulvérisation ionique selon un premier mode de réalisation de la présente invention ; et
la figure 5 est une vue en perspective illustrant une installation de pulvérisation ionique selon un deuxième mode de réalisation de la présente invention.

### Description détaillée

La figure 2 illustre de façon très schématique le principe de fonctionnement d'un dispositif de pulvérisation ionique selon un mode de réalisation de la présente invention. Dans ce dispositif, plusieurs cibles de petites dimensions 11 sont prévues autour d'un axe 13 normal à un substrat 15 sur lequel on veut effectuer un dépôt. Chacune de ces cibles est bombardée par un faisceau d'ions fourni par des sources 17.

On désigne par :
α, l'angle entre le plan d'une cible et la direction de l'axe 13,
a, la dimension latérale du substrat (son diamètre dans le cas d'un cercle ou son côté dans le cas d'un carré),
2r, la distance entre les cibles, et
d, la distance entre le substrat et la projection sur l'axe 13 du centre des cibles 11.

On note alors que, en fonction du choix des paramètres α, a, d et r, on peut obtenir un profil d'épaisseur de dépôt choisi sur le substrat.

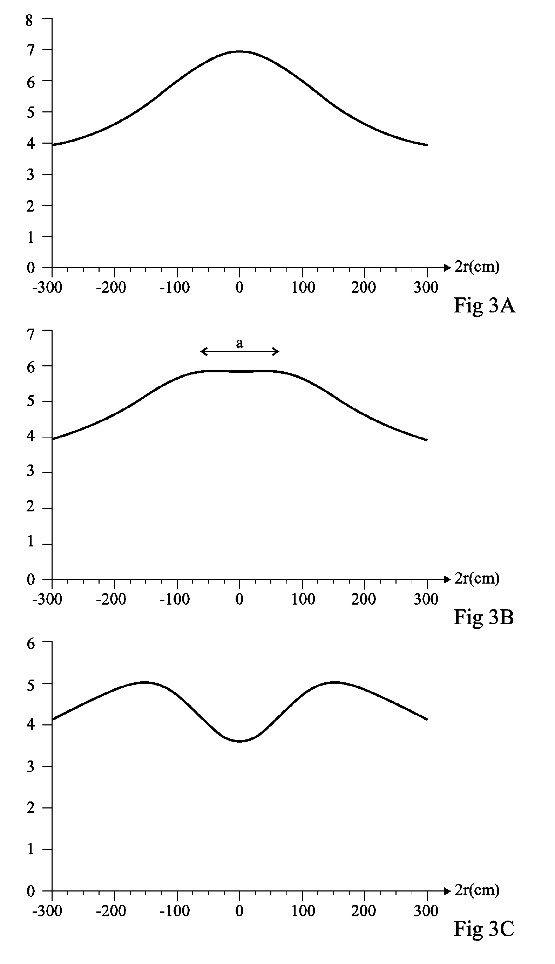

Trois exemples de profil d'épaisseur sont donnés par les figures 3A, 3B et 3C. Dans ces trois figures, l'angle α est égal à 30° et la distance d est égale à 15 cm. Dans le cas de la figure 3A, la valeur r est égale à 2 cm. Dans le cas de la figure 3B, la valeur r est égale à 4 cm et dans le cas de la figure 3C, la valeur r est égale à 8 cm. Ainsi, on constate que pour une distance cible-substrat de seulement de 15 cm, on peut obtenir comme l'illustre la figure 3B une homogénéité de dépôt (à mieux que 5 %) sur une étendue de 15 cm. On peut aussi obtenir des profils particuliers tels que ceux illustrés en figures 3A et 3C selon les valeurs de la distance r. La possibilité de modifier l'angle α fournit un paramètre de réglage supplémentaire.

Les exemples des figures 3A, 3B et 3C appliqués au dispositif schématique de la figure 2 sont donnés dans le cas d'une analyse purement unidimensionnelle. Si on répartit plusieurs sources à la périphérie de l'axe 13 de la figure 2, on pourra obtenir des profils tels que celui de la figure 3B sur tout un plan.

De plus, l'exemple de la figure 2 et des figures 3A-3C a été donné dans le cas où le faisceau d'ions est quasi ponctuel sur chaque cible. En pratique, les dimensions latérales de la section d'un faisceau d'ions sur une cible ne seront pas ponctuelles mais très petites. On choisira des dimensions au moins dix fois plus petites que celles du substrat, c'est-à-dire que la surface bombardée de la cible est plus de cent fois inférieure à la surface du substrat. On choisira avantageusement des énergies de faisceaux comprises entre 10 et 20 kV, des énergies comprises entre 0,1 et 10 kV pouvant être utilisées afin de régler finement de très faibles flux d'évaporation. Le flux global au niveau du substrat correspond à la somme des composantes de chaque source.

Comme on le verra dans les exemples de réalisation ci-après, les cibles, au lieu d'être des cibles distinctes de petites dimensions, pourront être des petites portions distinctes d'une même surface de matériau.

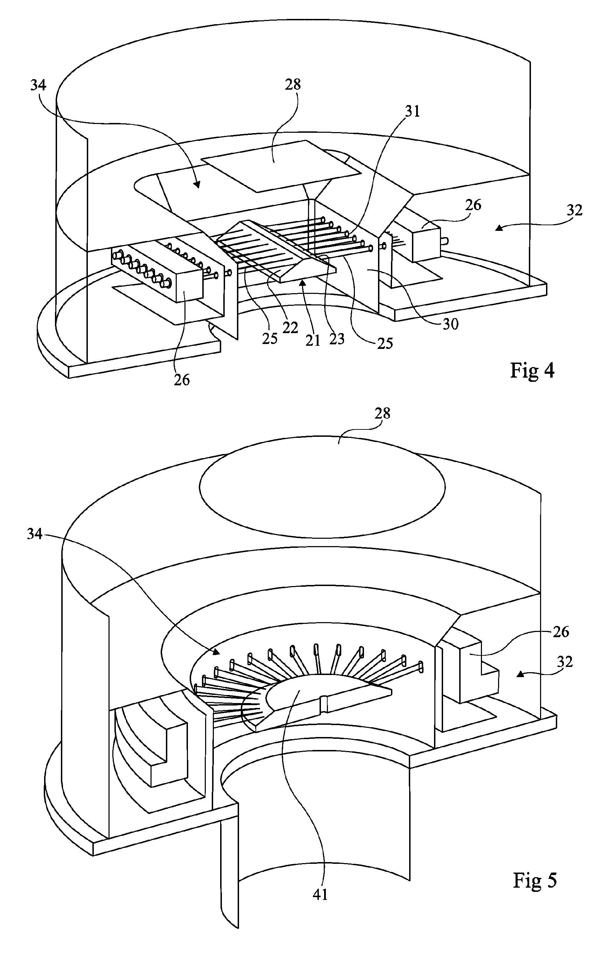

La figure 4 représente un premier exemple de réalisation d'une installation selon la présente invention. Dans cet exemple, La cible a la forme d'un élément prismatique 21 dont deux surfaces opposées 22 et 23 reçoivent, sur des zones distinctes, des faisceaux d'ions 25 provenant de sources d'ions 26 disposées de part et d'autre du prisme. Chaque faisceau d'ions éclaire une petite surface d'une face du prisme. Un substrat 28 est disposé horizontalement au dessus du prisme. On obtient alors en choisissant convenablement la distance (d) entre le substrat et le prisme, l'angle au sommet (α) du prisme et la distance (2r) entre les points d'impact sur des faces opposées du prisme, un revêtement du substrat qui peut être homogène si l'on se place dans des conditions similaires à celles décrites précédemment en relation avec la figure 3B, tout en conservant comme on l'a indiqué précédemment une petite distance entre le substrat 28 et les cibles.

On notera également que, dans l'exemple d'installation représenté en figure 4, les faisceaux d'ions arrivent sur le prisme en passant par des ouvertures 31 dans une paroi 30. Etant donnée la faible section des faisceaux d'ions, les ouvertures 31 peuvent être de petites dimensions. En conséquence, l'ensemble des sources d'ions 26 peut être placé dans une chambre périphérique 32 distincte d'une chambre 34 dans laquelle sont placés le prisme cible et le substrat 28. Les chambres 32 et 34 ne communiquant que par les petites ouvertures 31, on peut réaliser des vides dynamiques distincts dans ces chambres 32 et 34, ce qui permet d'optimiser indépendamment le fonctionnement des sources d'ions et celui de la zone de pulvérisation dans laquelle on peut injecter un gaz réactif pour le dépôt de couches chimiquement contrôlées.

La figure 5 qui ne sera pas décrite en détail représente une installation similaire à celle de la figure 4, mais dans laquelle les zones de cible au lieu de correspondre aux deux faces d'un prisme correspondent à la périphérie d'un cône 41. On a alors une structure de révolution qui peut être plus avantageuse dans certains cas.

En tant que sources d'ions multiples, on pourra utiliser des sources d'ions du type décrit dans la demande de brevet français 08/57068 du 17/10/2008 au nom du Centre National de la Recherche Scientifique, inventeurs P. Sortais et T. Lamy.

Différents gaz peuvent être utilisés pour le faisceau d'ions, on utilisera couramment de l'argon, mais les autres gaz généralement proposés dans de tels systèmes de pulvérisation ionique pourront être utilisés ici.

La cible pourra être du cuivre ou tout autre matériau simple ou combiné. D'autre part, on pourra utiliser plusieurs groupes de cibles différents pour différents matériaux dont on souhaite obtenir une combinaison sur le substrat. En ce cas, l'invention permet avantageusement de régler de façon optimale les faisceaux d'ions sur chacune des cibles de chacun des groupes de cibles.

Diverses modifications, améliorations et variantes pourront être mises en oeuvre. En particulier :
- le dispositif pourra comprendre un système de déplacement de l'ensemble des cibles, en rotation et/ou en translation, afin de contrôler la position et la forme de la zone d'usure de la cible ;
- un système de mesure du courant ionique de chaque faisceau pourra être placé sous l'ensemble des cibles et mobile avec celui-ci ;
- on pourra prévoir un système de mise en rotation-translation et/ou de chauffage et/ou d'immersion plasma et/ou de bombardement ionique et/ou de cache et/ou de polarisation du substrat ;
- le dispositif pourra comprendre un système de modulation de l'intensité des courants ioniques des sources.

## Revendications

1. Dispositif de dépôt d'un matériau choisi sur un substrat par pulvérisation ionique, comprenant :
une pluralité de cibles (11) d'un matériau choisi dont chacune est bombardée par un faisceau d'ions, les dimensions latérales de chacun des faisceaux d'ions étant inférieures au dixième des dimensions latérales du substrat (15) ;
une chambre de pulvérisation (34) contenant les cibles et le substrat et une chambre (32) contenant les sources de faisceaux d'ions, ces chambres étant séparées par une paroi munie d'ouvertures (31) de sections correspondant à la section des faisceaux d'ions; et
des moyens de pompage propres à entretenir des vides dynamiques distincts dans les deux chambres.

2. Dispositif selon la revendication 1, adapté au dépôt de plusieurs matériaux choisis, comprenant plusieurs pluralités de cibles, chaque pluralité étant associée à un matériau.

3. Dispositif selon la revendication 1 ou 2, dans lequel les cibles sont réparties de façon symétrique autour d'un axe de symétrie orthogonal au substrat et inclinées par rapport à la normale à celui-ci.

4. Dispositif selon la revendication 3, dans lequel les cibles sont disposées côte à côte en deux lignes de part et d'autre dudit axe et constituent deux surfaces d'un prisme.

5. Dispositif selon la revendication 3, dans lequel les cibles sont réparties circulairement et constituent la surface d'un cône.

6. Dispositif selon la revendication 1, comprenant un système de déplacement de l'ensemble des cibles, en rotation et/ou en translation.

7. Dispositif selon la revendication 1, comprenant un système de mesure du courant ionique de chaque faisceau placé sous l'ensemble des cibles et mobile avec celui-ci.

8. Dispositif selon la revendication 1, comprenant en outre un système assurant au moins l'une des fonctions suivantes : mise en rotation-translation, chauffage et/ou immersion plasma, bombardement ionique et/ou cache, et polarisation du substrat.

9. Procédé de dépôt d'un ou plusieurs matériaux choisis sur un substrat par pulvérisation ionique, au moyen d'un dispositif selon l'une quelconque des revendications 1 à 8 comprenant les étapes suivantes :
bombarder chacune des cibles par un faisceau d'ions ; et
sélectionner la distance (2r) entre cibles, la distance (a) entre cibles et substrat et l'orientation (α) des cibles par rapport au substrat pour obtenir un profil de dépôt choisi sur le substrat.

## Patentansprüche

1. Eine Vorrichtung zum Abscheiden eines ausgewählten Materials auf einem Substrat durch Ionensputtering wobei folgendes vorgesehen ist:
eine Vielzahl von Zielen oder Targets (11) aus einem ausgewählten Material, wobei jedes der Targets durch einen Ionenstrahl bombadiert wird, wobei die seitlichen Dimensionen jeder der Ionenstrahlen kleiner ist als ein Zehntel der seitlichen Dimensionen des Substrats (15);
eine Sputterkammer (34) die die Targets und das Substrat enthält und eine Kammer (32) die die Ionenstrahlquellen enthält, wobei die Kammern durch eine Wand versehen mit Öffnungen (31) getrennt sind, die einen Querschnitt entsprechend dem Querschnitt der Ionenstrahlen besitzen; und
Pumpmittel die in der Lage sind unterschiedliche dynamische Vakua in den zwei Kammern aufrecht zu erhalten.

2. Die Vorrichtung nach Anspruch 1, die in der Lage ist mehrere ausgewählte Materialien abzuscheiden und mehrere Vielzahlen von Targets aufweist, wobei jede Vielzahl mit einem Material assoziiert ist.

3. Die Vorrichtung nach Anspruch 1 oder 2 wobei die Targets symmetrisch verteilt sind um eine Symmetrieachse herum orthogonal zum Substrat und geneigt bezüglich der Normalen dazu.

4. Die Vorrichtung nach Anspruch 3, wobei die Targets Seite an Seite in zwei Linien auf jeder Seite der erwähnten Achse angeordnet sind und zwei Oberflächen eines Prismas bilden.

5. Die Vorrichtung nach Anspruch 3 wobei die Targets kreisförmig verteilt sind und die Oberfläche eines Konus bilden.

6. Die Vorrichtung nach Anspruch 1 die ein System aufweist um die Anordnung der Targets zu drehen und/oder zu verschieben.

7. Die Vorrichtung nach Anspruch 1 die ein System aufweist zur Messung des Ionenstroms jedes Strahls und zwar platziert unter der Targetanordnung und beweglich damit.

8. Die Vorrichtung nach Anspruch 1 ferner ein System aufweisend zur Durchführung mindestens einer der folgenden Funktionen: Rotation-Verschiebung, Erhitzung und/oder Plasmaimmersion, Ionenbombardement und/oder Cache und eine Substratpolarisation.

9. Ein Verfahren zum Abscheiden eines oder mehrerer ausgewählter Materialien auf einem Substrat durch Ionensputtering mittels der Vorrichtung nach einem der Ansprüche 1-8 wobei die folgenden Schritte vorgesehen sind:
Bombardieren jedes der Targets mit einem Ionenstrahl; und
Auswählen des Abstandes (2r) zwischen den Targets, des Abstands (a) zwischen den Targets und dem Substrat, und die Targetorientierung (α) bezüglich des Substrats um ein ausgewähltes Abscheidungsprofil auf dem Substrat zu erhalten.

## Claims

1. A device for depositing a selected material on a substrate by ion sputtering, comprising:
a plurality of targets (11) of a selected material, each of which is bombarded by an ion beam, the lateral dimensions of each of the ion beams being smaller than one tenth of the lateral dimensions of the substrate (15);
a sputtering chamber (34) containing the targets and the substrate, and a chamber (32) containing the ion beam sources, the chambers being separated by a wall provided with openings (31) having a cross-section corresponding to the cross-section of the ion beams; and
pumping means capable of maintaining distinct dynamic vacuums in the two chambers.

2. The device of claim 1, capable of depositing several selected materials, comprising several pluralities of targets, each plurality being associated with a material.

3. The device of claim 1 or 2, wherein the targets are symmetrically distributed around an axis of symmetry orthogonal to the substrate and inclined with respect to the normal thereto.

4. The device of claim 3, wherein the targets are arranged side by side in two lines on either side of said axis and form two surfaces of a prism.

5. The device of claim 3, wherein the targets are circularly distributed and form the surface of a cone.

6. The device of claim 1, comprising a system for rotating and/or shifting the assembly of targets.

7. The device of claim 1, comprising a system for measuring the ion current of each beam placed under the target assembly and mobile therewith.

8. The device of claim 1, further comprising a system performing at least one of the following functions: rotating-shifting, heating and/or plasma immersion, ion bombarding and/or cache, and substrate biasing.

9. A method for depositing one or several selected materials on a substrate by ion sputtering, by means of the device of any of claims 1 to 8, comprising the steps of:
bombarding each of the targets with an ion beam; and
selecting the distance (2r) between targets, the distance (a) between targets and substrate, and the target orientation (α) with respect to the substrate to obtain a selected deposition profile on the substrate.
